# FASCICULE DE BREVET EUROPEEN

(11) **EP 0 415 806 B1**
(45) Date de publication et mention de la délivrance du brevet: **26.05.1993**
(21) Numéro de dépôt: 90402105.2
(22) Date de dépôt: 23.07.1990
(51) Int. Cl.: H05K 3/46

(54) **Procédé de dépôt d'une couche isolante sur une couche conductrice du réseau multicouche d'une carte de connexion de circuit intégré de haute densité, et carte en résultant**
Verfahren zur Ablagerung einer isolierenden Schicht auf einer leitenden Schicht des mehrschichtigen Netzes einer gedruckten Schaltung mit Leiterbahnen hoher Dichte und eine dadurch erhaltene Leiterplatte
Method for the depositing of an insulating layer on a conductive layer of a multilayer net-printed circuit board with a high density pattern and such board

(30) Priorité: 27.07.1989 FR 8910158
(43) Date de publication de la demande: 06.03.1991
(73) Titulaire: BULL S.A., 92800 Puteaux (FR)
(72) Inventeur: Chantraine, Philippe, F-75116 Paris (FR); Zorrilla, Marta, F-75116 Paris (FR)
(74) Mandataire: Denis, Hervé

(56) Documents cités:
- EP-A- 0 247 575
- EP-A- 0 256 778

## Description

L'invention a pour objet un procédé de dépôt d'une couche isolante sur une couche conductrice du réseau multicouche d'une carte de connexion d'au moins un circuit intégré de haute densité encore appelé circuit VLSI (Very Large Scale Integrated circuit). La carte peut servir à l'interconnexion de plusieurs circuits intégrés montés en surface ou simplement de support d'un circuit intégré placé dans un boîtier, par exemple en substitution du support classique actuel couramment appelé "chip carrier".

Dans une telle carte, le réseau multicouche est ordinairement porté par un substrat fait d'une plaque isolante incorporant les plans de distribution des potentiels d'alimentation du ou des circuits intégrés. Le substrat peut être une plaque de céramique cocuite, ou une plaque faite d'un matériau organique, en plastique par exemple. Cependant, la carte pourrait être simplement formée du réseau multicouche prenant la forme d'une carte souple. La carte peut encore être une plaque de matériau semiconducteur incorporant des circuits intégrés et recouverte d'un réseau multicouche pour l'interconnexion de ces circuits intégrés selon la technologie dite WSI (Wafer Scale Integration). Dans toutes ces cartes, le réseau multicouche se compose d'un empilement de couches conductrices et isolantes alternées. Dans cet empilement, une couche isolante est percée de traversées pour la liaison électrique des couches conductrices adjacentes. La couche conductrice est ordinairement faite d'aluminium ou de cuivre, et la couche isolante est aujourd'hui faite de préférence en un matériau polymérisé tel que le polyimide.

Un problème dans la fabrication du réseau multicouche réside dans l'obtention de couches relativement planes. Un procédé classique de fabrication consiste à former les conducteurs d'une couche conductrice et à recouvrir la couche conductrice d'une couche isolante de matériau polymérisable sous forme de liquide visqueux, appelé couramment pâte. Cette pâte offre l'avantage d'avoir une surface présentant des marches ou dénivellations moins hautes que les bords correspondants des conducteurs sous-jacents. Ce procédé peut consister en l'étalement centrifuge d'une goutte d'un matériau polymérisable, ou en une pulvérisation de la pâte, ou encore en une enduction de la pâte, par sérigraphie par exemple. La pâte est ensuite polymérisée. Naturellement, les conditions de mise en oeuvre de ce procédé confèrent à la couche polymérisée la grande épaisseur requise pour assurer l'isolation désirée entre deux couches conductrices superposées. La couche isolante est recouverte d'un masque définissant les emplacement des traversées (via - holes en terminologie anglo-saxonne) à former. Selon un mode de réalisation classique, les traversées sont évasées, et les conducteurs de la couche conductrice supérieure s'étendent sur la couche isolante et sur les parois des traversées qui viennent d'être formées, ainsi que sur les régions des conducteurs constituant le fond des traversées. Il en résulte une couche conductrice supérieure pourvue de nombreuses dépressions au niveau des traversées. On comprend que l'empilement de nombreuses couches accentue la profondeur des dépressions et risque en conséquence de créer des discontinuités dans les couches conductrices déposées. De plus, la formation et l'évasement des traversées sont des étapes délicates du procédé.

Un perfectionnement à ce procédé consiste à éviter la superposition de traversées, en les décalant en spirale autour d'une ligne verticale. Un premier inconvénient est de réduire la densité des traversées dans une même couche isolante et, par voie de conséquence, de réduire la densité globale des conducteurs dans le réseau multicouche. Comme second inconvénient, la disposition décalée des traversées limite quand même très vite le nombre de couches fiables dans le réseau. Par exemple, une disposition en spirale à 90° les unes des autres fait qu'une traversée de la cinquième couche se superpose à une traversée de la première couche et subit les déformations occasionnées par les quatre traversées intermédiaires. En pratique, ce procédé est ordinairement limité au dépôt de l'ordre de cinq couches conductrices superposées.

Une solution plus récente au problème consiste à former des piliers sur des conducteurs d'une couche conductrice et à recouvrir l'ensemble d'une pâte que l'on polymérise pour obtenir la couche isolante. La couche isolante a la grande épaisseur requise pour assurer l'isolation désirée entre deux couches conductrices superposées et recouvre les piliers d'une plus faible épaisseur de matériau isolant. La couche isolante est recouverte d'un masque ayant la configuration des traversées. On procède alors à une attaque sélective de la couche isolante pour découvrir les faces supérieures des piliers et pour évaser les traversées. A cause des piliers, ces traversées sont nettement moins profondes que celles obtenues par le procédé décrit dans le paragraphe précédent. La couche conductrice supérieure est donc relativement plus aplanie.

Le problème que pose cette solution ressortira clairement de l'exemple suivant d'un procédé classique de formation d'une couche isolante polymérisée sur une couche conductrice pourvue de piliers. On suppose que la couche conductrice est formée sur une surface plane de référence et composée de conducteurs ayant une hauteur pourvue de piliers de hauteur H par rapport à la surface de référence. Sur cette couche conductrice, on dépose une goutte d'une pâte visqueuse d'acide polyamique. Par rotation, la goutte s'étale sur l'ensemble de la couche conductrice suivant une épaisseur T0 dépendant de la viscosité de la pâte, de la vitesse de rotation et du relief de la couche conductrice. Dans un four, on procède à la précuisson de la pâte. La température de la précuisson doit être inférieure à la température d'imidisation (de l'ordre de 220°C) à partir de laquelle a lieu la polymérisation de la pâte. La précuisson fige l'acide polyamique et élimine une partie du solvant incorporé dans la pâte. Cette partie dépend de la température de la précuisson, comprise en pratique entre 130°C et 200°C environ. L'épaisseur T1 de la couche précuite dépend de la quantité de solvants restant dans la couche et, par conséquent, de la température de la précuisson et de la nature de la pâte. L'épaisseur T1 d'une pâte standard précuite au voisinage de la température d'imidisation peut être réduite jusqu'à environ 40 % de l'épaisseur T0 de la pâte. La couche précuite est ensuite polymérisée, à une température ordinairement de l'ordre de 400°C. La couche de polyimide en résultant a une épaisseur T2 plus petite que l'épaisseur T1 d'une grandeur dépendant de la nature de la pâte et de la température de précuisson. Au total, pour une pâte ordinaire, l'épaisseur T2 est de l'ordre de 50% de l'épaisseur T0 de la couche initiale de pâte. La surface de polyimide est globalement plane et présente des marches au niveau des bords des conducteurs et des piliers.

Soit s la hauteur de marche relative à la hauteur h d'un conducteur et S la hauteur d'une marche relative à la hauteur H d'un pilier par rapport à la surface de la couche isolante sous-jacente. Le facteur d'aplanissement de la couche isolante est défini par un nombre couramment appelé facteur DOP (Degree Of Planarization) = 1-s/h. Cette formule est valable quelle que soit la valeur h et si la hauteur de la pâte étalée initialement sur la couche conductrice est sensiblement égale ou supérieure à la valeur h. Par conséquent, dans les mêmes conditions on a aussi le facteur DOP = 1-s/H. Le facteur DOP d'une couche standard actuelle est l'ordre de 0,4. Cela signifie que si h = 5 micromètres, s = 3 micromètres, et si H = 20 micromètres, H = 12 micromètres. L'importance de la marche S due aux piliers conduit actuellement à réduire la hauteur H des piliers. Cependant, la couche isolante doit avoir une épaisseur minimale relativement élevée pour assurer une bonne isolation électrique entre les couches conductrices superposées. Une faible hauteur de piliers exige donc de faire des traversées relativement profondes dans la couche isolante. Par conséquent, avec les produits standards actuels, la solution consistant à introduire des piliers dans la couche conductrice apporte au procédé classique décrit précédemment un perfectionnement relativement peu important pour améliorer la planéité d'une couche isolante. En vue de réduire la hauteur des marches, les fabricants étudient actuellement des produits ayant un facteur DOP plus élevé. Cependant, les marches subsisteront et devront être ouvertes, selon la technologie classique, pour former des traversées découvrant les faces supérieures des piliers. On a vu que la formation des traversées est une opération délicate. Elle exige en effet le dépôt d'un masque et le positionnement très précis des ouvertures définissant les emplacements des traversées au-dessus des piliers. En outre, la durée de la gravure est déterminée conventionnellement par des moyens optiques qui détectent l'apparition du métal des piliers. Dans le cas présent, ces moyens optiques doivent agir dans des traversées qui rendent difficiles la détection du métal . Si la détection est faite prématurément, la présence d'une pellicule restante de polyimide affectera la qualité du contact électrique du pilier avec la couche conductrice supérieure.

Le problème actuel consiste donc à utiliser des pâtes ordinaires, peu chères, fiables, pour obtenir une surface sensiblement plane indépendamment de la hauteur des piliers de la couche conductrice sous-jacente, et à ne plus faire de traversées dans la couche isolante sensiblement plane. Ce procédé offrirait donc l'avantage d'empiler un grand nombre de couches conductrices fiables, isolées correctement et de manière fiable par des couches isolantes sensiblement planes. L'invention a pour objet un tel procédé.

Le procédé conforme à l'invention pour la formation d'un réseau multicouche de connexion d'au moins un circuit intégré de haute densité, comprenant les étapes successives du procédé tel que décrit à la revendication 1.

Il en résulte une carte de connexion d'au moins un circuit intégré de haute densité, comprenant un réseau multicouche composé de couches conductrices et isolantes alternées, chaque couche conductrice incluant des conducteurs surmontés de piliers, caractérisée en ce que les couches isolantes sont sensiblement coplanaires avec les faces supérieures des piliers de la couche conductrice sous-jacente.

Les caractéristiques et avantages de l'invention ressortiront de la description qui suit, donnée à titre d'exemple et faite en référence aux dessins annexés.

Dans les dessins :
- la figure 1 est une vue en coupe partielle transversale d'une carte de connexion d'au moins un circuit intégré de haute densité, qui incorpore un réseau multicouche obtenu par le procédé conforme à l'invention ;
- les figures 2A à 2H sont des vues partielles du réseau multicouche représenté sur la figure 1, illustrant des phases successives d'un procédé conforme à l'invention pour la formation de la seconde couche isolante du réseau multicouche ; et
- les figures 3A à 3E sont des vues de détail agrandi du réseau multicouche représenté sur la figure 1, illustrant des phases successives d'une variante du procédé conforme à l'invention pour la formation de la seconde couche isolante du réseau multicouche de la figure 1.

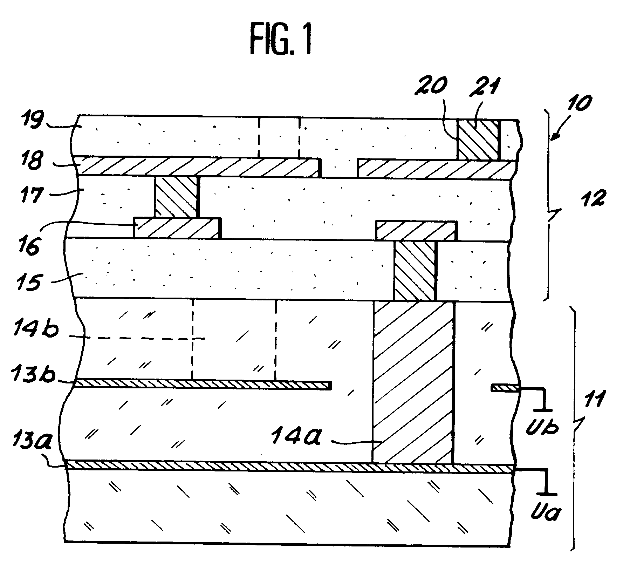

La figure 1 présente une carte 10 conforme à l'invention, vue en coupe partielle. La carte 10 se compose d'un substrat 11 portant sur une face un réseau multicouche 12 pour la connexion d'au moins un circuit intégré de haute densité, non illustré. Le substrat 11 est ordinairement une plaque massive, de céramique par exemple, incorporant des plans 13a, 13b de distribution des potentiels respectifs Ua, Ub d'alimentation des circuits intégrés qui seront montés sur la carte. De nombreux piliers conducteurs 14a, 14b traversent le substrat 11, faisant contact avec les plans de potentiel respectifs 13a, 13b et émergeant sur une même face du substrat 11. Le réseau multicouche 12 est formé sur cette face du substrat 11. Le réseau 12 est un empilement de couches conductrices et isolantes alternées, comprenant une première couche isolante 15, une première couche conductrice 16, une seconde couche isolante 17, une seconde couche conductrice 18, et une troisième couche isolante 19 destinée à porter le circuit intégré. Les couches isolantes 15, 17, 19 sont pourvues de traversées 20 pour la liaison électrique des plans conducteurs 14 et des couches conductrices 16 et 18 au circuit intégré non représenté. Chaque traversée 20 contient un pilier conducteur 21 ayant la hauteur de la traversée et, dans l'exemple illustré, une section transversale sensiblement uniforme. Les piliers 21 peuvent avoir une section transversale cylindrique ou prismatique.

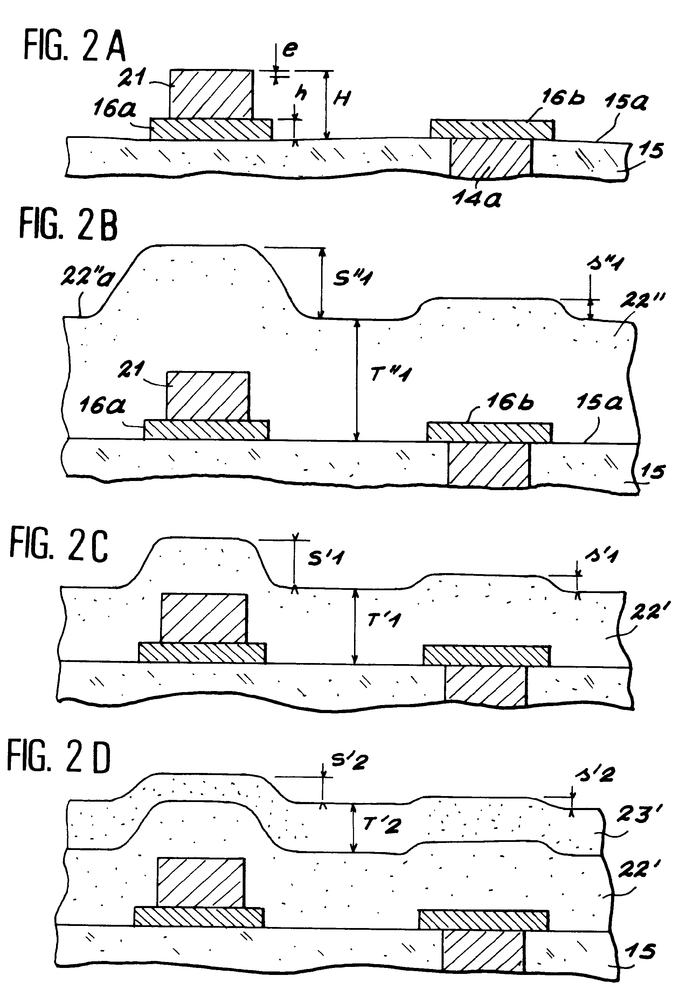

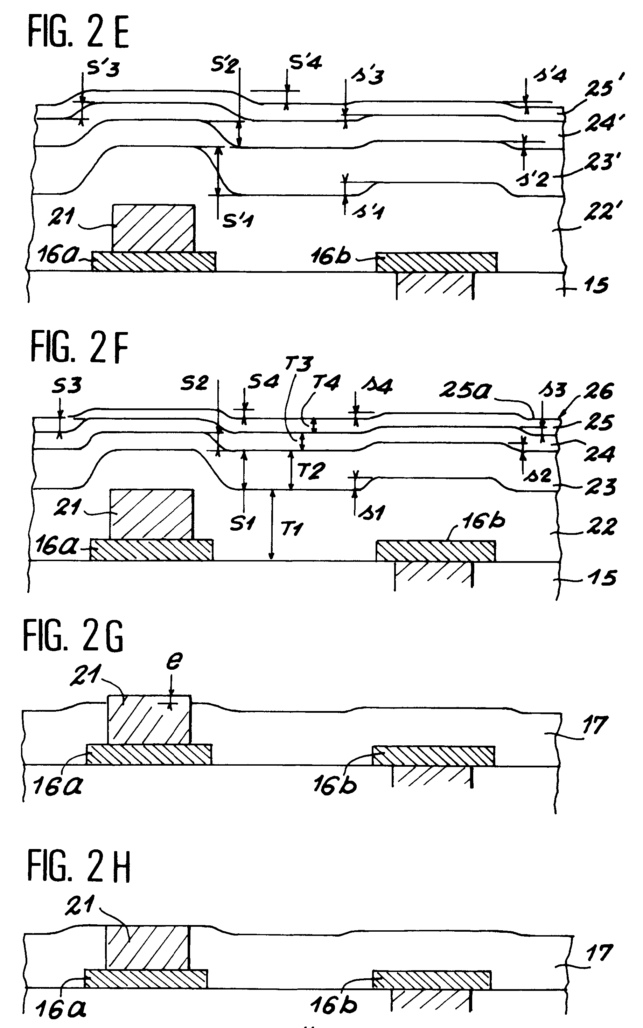

Les figures 2A à 2H sont des vues illustrant les phases successives d'un premier procédé conforme à l'invention pour la formation de l'une quelconque des couches isolantes, celle choisie pour l'exemple étant la seconde couche isolante 17 sur la couche conductrice 16 du réseau multicouche 12 représenté sur la figure 1. La figure 2A illustre la première étape du procédé. La couche conductrice 16 se compose de deux conducteurs 16a, 16b déposés sur la couche isolante 15 formée conformément à l'invention. Afin de mieux mettre en relief les caractéristiques de l'invention, la couche isolante 15 est supposée avoir une surface supérieure 15a plane, comme illustré, servant de référence aux diverses hauteurs et épaisseurs qui vont être données. Dans l'exemple réalisé, les conducteurs 16a, 16b, comme tous les autres conducteurs des couches 16 et 18, ont une hauteur h = 5 micromètres. Le conducteur 16a illustré porte un pilier de hauteur H = 17 micromètres. Le conducteur 16b illustré est en contact avec un pilier sous-jacent 21 de la couche isolante 15. Dans le réseau 12 réalisé, les piliers étaient formés sur des bases élargies des conducteurs d'une couche conductrice et avaient une hauteur finale H = 15 micromètres. Une particularité de l'exemple du procédé représenté sur les figures 2A-2H consiste à former initialement des piliers d'une hauteur légèrement supérieure (H = 17 micromètres) d'une grandeur e (2 micromètres par exemple) par rapport à la hauteur finale désirée, pour les raisons qui ressortiront clairement ultérieurement.

Les figures 2B et 2C illustrent respectivement deux phases du procédé classique de formation d'une couche isolante à partir d'un matériau polymérisable sur une couche conductrice. Sur la couche conductrice 16 représentée sur la figure 2A a été déposée une goutte d'une pâte d'acide polyamique couramment utilisée à l'heure actuelle, telle que celle fabriquée par la Société DuPont de Nemours sous la référence PI 25-25, dont le facteur d'aplanissement DOP est de 0,4. La carte 10 dans cet état a été mise en rotation pour étaler par la force centrifuge la pâte uniformément sur toute la couche conductrice 16 afin d'obtenir une couche de pâte 22'' ayant une épaisseur T''1 par rapport à la surface de référence 15a. Compte tenu du facteur DOP de la pâte, la surface supérieure 22''a de la couche 22'' présente des marches s''1 au niveau des faces latérales, verticales, des conducteurs seuls tels que le conducteur 16b et des marches de hauteur S''1 au niveau des faces latérales des piliers 21 portés par leurs conducteurs associés tels que le conducteur 16a. Ensuite, la carte 10 est placée dans un four pour faire une précuisson de la couche de pâte 22''. La précuisson se fait à une température inférieure à la température d'imidisation de la pâte (220°C). En fonction de la température, la pâte de la couche 22'' libère une partie de ses solvants et se présente sous la forme d'une masse figée d'acide polyamique. On obtient ainsi une couche d'acide polyamique figée 22' (figure 2C) d'épaisseur T'1 sensiblement plus réduite que l'épaisseur T''1 de la couche 22'' (figure 2B). Les marches correspondantes s'1 et S'1 ont des hauteurs réduites dans le même rapport.

Un procédé classique de formation d'une couche isolante dans un réseau multicouche 12 consiste à imidiser ensuite la couche 22'. Il en résulte une couche 22 (figure 2F) ayant une épaisseur T1 et présentant des marches s1 et S1 propotionnelles dans le même rapport. Ce procédé se poursuivait par une attaque sélective de la couche 22 afin de découvrir les faces supérieures des piliers 21.

Le procédé conforme à l'invention consiste à former plusieurs strates 23, 24, 25 (figure 2F) successives de polyimide, jusqu'à obtenir une surface supérieure 25a présentant des marches s4, S4 d'une hauteur maximale sensiblement égale ou inférieure à une valeur désirée V. Dans l'exemple choisi, la valeur désirée V était de l'ordre de 2 micromètres. La couche 22 servant de première strate avait une épaisseur sensiblement égale à la hauteur H = 17 micromètres des piliers 21. Compte tenu du facteur DOP = 0,4, la surface 22a de la strate 22 présentait des marches S1 = 10,2 micromètres et s1 = 3 micromètres. La couche de pâte 22'' (figure 2B) avait dans ces conditions une épaisseur T''1 = 30 micromètres environ et des marches S''1 = 18 micromètres et s''1 = 5 micromètres, environ. La précuisson a été faite à environ 200°C pendant une heure pour aboutir à la strate 22' (figure 2C) ayant une épaisseur T'1 = 19 micromètres et des marches S'1 = 11 micromètres et s'1 = 3 micromètres, environ.

la seconde strate 23 de polyimide (figure 2F) a été formée de la même manière qu'aux figures 2B et 2C, en considérant les marches S1 et s1 de la première strate 22 comme l'équivalent des hauteurs H et h de la couche conductrice 16 représentée sur la figure 2A. En d'autres termes, les marches S2 et s2 de la seconde strate 23 sont données par la formule du facteur DOP : 0,4 = 1 - S2/S1 = 1 - s2/s1. En prenant comme règle d'étaler une pâte de façon à obtenir une épaisseur de couche de polyimide pratiquement égale à la plus grande hauteur de marche, la seconde strate 23 avait une épaisseur T2 = S1 = 10 micromètres, et sa surface 23a avait des marches S2 = 6 micromètres et s2 = 2 micromètres. La deuxième strate 23 de polyimide a été obtenue à partir d'une strate d'acide polyamique 23' (figure 2D) précuit dans les mêmes conditions que la strate 22' de la figure 2C. La masse de la strate 23' est plus élevée, étant donné qu'elle n'a pas encore été imidisée.

De même, on a déposé et précuit une troisième strate 24' (figure 2E), que l'on a imidisée pour obtenir la strate 24 (figure 2F) ayant une épaisseur T3 = S2 = 6 micromètres et des marches de hauteur S3 = 3, 6 micromètres et s3 = 1 micromètre. Etant donné que la marche S3 est encore nettement supérieure à la valeur maximale désirée V = 2 micromètres, une quatrième strate 25' (figure 2E) a été formée de façon à obtenir après imidisation la quatrième strate de polyimide 25 (figure 2F) ayant une épaisseur T4 = S3 = 3,6 micromètres et des marches de hauteur S4 = 2 micromètres et s4 = 0,7 micromètre. La quatrième strate 25 est la dernière, puisque ses marches de hauteur maximale S4 sont sensiblement égales à la valeur désirée V. On obtient ainsi la couche isolante stratifiée 26'.

En pratique, on forme par précuisson chacune des strates 22'-25' (figure 2E), puis on procède à l'imidisation de toute la masse d'acide polyamique précuit de la couche 26'. Dans l'exemple choisi, la carte 10 a subi une cuisson de 400°C pendant un cycle de l'ordre de 11 heures pour effectuer l'imidisation de la couche 26'. Il en résulte la couche stratifiée de polyimide 26 de la figure 2F. La couche 26 est ensuite gravée de façon anisotrope et uniforme, jusqu'à découvrir les faces supérieures des piliers 21. Dans ces conditions, on obtient la couche isolante finale 17 (figure 2G). Etant donné que la gravure ne modifie pas la topologie de la face 25a de la dernière strate 25, la couche 17 présente des marches ayant les hauteurs S4 et s4 de la quatrième strate 25. La gravure a été faite selon le procédé classique par plasma d'ions réactifs sous oxygène associé à un composé fluoré, procédé plus connu sous le nom de Plasma Reactive Ion Etching. Ce procédé a l'avantage d'avoir une vitesse d'attaque d'environ 0,7 micromètre par minute, c'est-à-dire trois à quatre fois plus rapide que le procédé plus courant de gravure par plasma sous oxygène pur.

Selon une caractéristique supplémentaire de l'invention, la gravure de la couche de polyimide 26 ne s'est pas arrêtée au niveau de la face supérieure du pilier 21 indiqué à la figure 2G, mais à un niveau légèrement plus bas de la grandeur e (2 micromètres dans l'exemple réalisé) indiquée à la figure 2A. L'élimination des 2 micromètres supérieurs des piliers 21 les met au même niveau que le polyimide environnant de la couche 17 (figure 2H). Cette élimination résout un problème de la technique antérieure. Selon cette technique, on a vu que la couche 22' dans la figure 2C était imidisée, puis gravée pour découvrir la face supérieure des piliers 21. Cependant, les défauts microscopiques de surface du métal des piliers 21 contribuaient à laisser des parties de polyimide et à altérer la qualité mécanique et électrique des contacts entre les piliers et les conducteurs de la couche supérieure. L'invention permet d'offrir une surface métallique exempte de polyimide sur chaque pilier 21. Cette gravure a été obtenue par une procédé ionique, mais elle aurait pu aussi se faire par un rodage mécanique ou par attaque chimique, notamment.

L'invention procure de nombreux avantages. Essentiellement, elle présente un procédé de formation d'une couche isolante sensiblement plane indépendamment de la hauteur des piliers de la couche éléctrique sous-jacente. En outre, la gravure uniforme de la couche isolante stratifiée aboutit à une couche isolante finale coplanaire avec les piliers tout en ayant l'épaisseur assurant l'isolation électrique désirée entre deux couches conductrices superposées. De plus, la gravure uniforme supprime les étapes de dépôt d'un masque et de son positionnement pour la formation de traversées, et offre une sensibilité nettement améliorée pour la détermination de la fin de la gravure. En effet, le contraste entre les surfaces métalliques et de polyimide apparait nettement sur toute la surface sensiblement plane de la couche stratifiée et confère une bonne maîtrise du procédé de gravure. On a tiré profit de cet avantage en élevant légèrement (de 2 micromètres) la hauteur des piliers 21 afin qu'ils puissent être réduits d'autant pour présenter une surface métallique assurant un contact mécanique et électrique fiable. D'autre part, le procédé de formation de la couche isolante stratifiée ne fait intervenir que des étapes bien connues et bien maîtrisées de formation d'une couche de polyimide. Enfin, un procédé conforme à l'invention peut subir diverses variantes, comme cela va être montré maintenant.

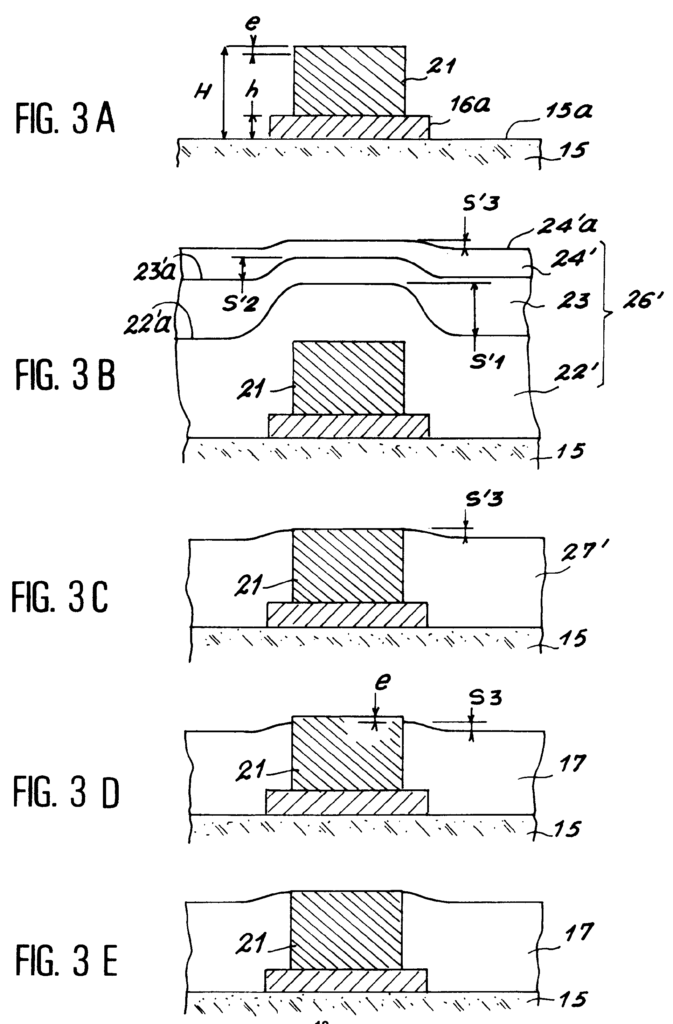

Les figures 3A à 3E sont des vues de détail agrandi au niveau d'un conducteur surmonté d'un pilier de la couche conductrice 16, illustrant des phases successives d'un second procédé conforme à l'invention pour la formation de la seconde couche isolante 17 du réseau multicouche 12 représenté sur la figure 1. Les figures 3A et 3B correspondent aux figures 2A et 2E. Dans la figure 3A, la couche isolante 15, formée conformément au procédé de l'invention et ayant une surface 15a de référence supposée plane, supporte un conducteur 16a de hauteur h = 5 micromètres surmonté d'un pilier 21 de hauteur H = 17 micromètres. Comme dans le premier procédé décrit précédemment, l'objectif est d'avoir une couche isolante finale 17 présentant des marches d'une hauteur S au plus égale à V = 2 micromètres environ. La pâte utilisée était fabriquée par la Société General Electric et avait un facteur DOP = 0,5 donnant un polyimide siloxane. Les strates successifs, obtenus par pulvérisation de la pâte suivie d'une précuisson, sont illustrés dans la figure 3B. Dans l'exemple illustré, l'épaisseur de chaque strate correspond environ à la hauteur des marches de la couche sous-jacente, comme dans le procédé précédent. En appliquant la formule du facteur DOP, valable pour une couche imidisée, la marche S1 calculée est de 8,5 micromètres. A cette valeur correspond, pour la couche de pâte 22' précuite à 200°C une marche légèrement supérieure, de l'ordre de 10 micromètres. La deuxième couche de pâte précuite 23' a été déposée pour obtenir une seconde strate de polyimide ayant une marche S2 calculée de 4,25 micromètres. A cette valeur correspond sur la surface 23'a de la couche 23' une marche S'2 légèrement inférieure à 5 micromètres. L'application d'une troisième couche 24' aboutit à une marche S3 dont la valeur calculée est de 2,12 micromètres. La surface 24'a de la troisième strate 24' de pâte précuite présente ainsi une marche de 2,5 micromètres environ. Il importe de noter que les plus grandes marches de hauteur S3 de la troisième strate 24 résultant de l'imidisation de l'ensemble des couches de la figure 3B sont sensiblement égales à la valeur prédéterminée désirée de 2 micromètres pour la couche isolante finale 17. Par conséquent, dans l'exemple illustré, cette valeur a été obtenue par le dépôt de trois strates seulement.

Conformément au second procédé, la gravure a été faite avant imidisation de la couche 26' formée des trois strates 22', 23' et 24'. En pratique, la gravure a été faite dans une solution d'hydrazine hydrate pure, à la vitesse de l'ordre de 0,4 micromètres par minute. La gravure s'est arrêtée au moment où la face supérieure des piliers 21 est apparue. La couche gravée 27' ainsi obtenue est représentée sur la figure 3C. La carte 10 a ensuite subi une cuisson de 400°C pendant un cycle de l'ordre de 11 heures pour effectuer l'imidisation de la couche 27'. La couche isolante finale de polyimide 17 a été ainsi formée (figure 3D). Cette couche reproduit les marches de la surface 24'a de la figure 3B. Compte tenu de l'imidisation, ces marches ont une valeur maximale de l'ordre de 2 micromètres, comme désiré. Après imidisation et l'élimination des solvants que contenait la couche de pâte précuite 27' (figure 3C), la couche 17 s'est légèrement rétractée et se trouve à un niveau légèrement inférieur à celui de la surface supérieure des piliers 21. L'élimination correspondante du métal des piliers pour les mettre au niveau de la couche isolante 17 (figure 3E) permet, comme dans le procédé précédent, d'obtenir une surface métallique exempte de polyimide et d'assurer un bon contact avec la couche conductrice supérieure 18.

Un autre exemple de réalisation se rapporte à une carte portant des piliers de hauteur H = 17,3 micromètres, et utilisait une pâte de polyimide référencée THERMID EL-5512 et fabriquée par la Société National Starch and Chemical Corporation résidant aux U.S.A.. Trois couches successives ont été déposées conformément au premier procédé décrit en référence aux figures 2, avec la différence que les couches finales avaient chacune une épaisseur égale à 10 micromètres environ. Trois couches ont suffi pour obtenir une marche S3 = 1,7 micromètre. La gravure s'est faite par plasma d'ions réactifs à base d'oxygène et d'un gaz fluoré. La vitesse d'attaque était d'environ de 0,6 micromètres par minute.

La généralisation du procédé conforme à l'invention peut se faire en référence au facteur DOP. Pour la première strate 22, on a : DOP = 1 - S1/H, d'où S1 = H (1 - DOP). Pour la deuxième strate 23, DOP = 1 - S2/S1, d'où S2 = S1 (1 - DOP) = H (1 - DOP)². Par itération, on a Sn = H (1 - DOP)ⁿ. Par conséquent, le principe de l'invention consiste à accroître artificiellement le facteur DOP d'un matériau polymérisable, en constituant une couche stratifiée. Le cas limite de l'invention est celui utilisant un matériau dont le facteur DOP est suffisant pour obtenir des marches maximales S sensiblement égales ou inférieures à la valeur désirée V avec une seule couche ayant l'épaisseur requise pour assurer l'isolation désirée entre couches conductrices superposées adjacentes. Dans ce cas, il suffit de faire une gravure uni forme de cette couche pour aboutir à la couche finale désirée, telle que représentée sur la figure 1, par exemple.

Il est à noter que le procédé n'est pas limité au polyimide et pourrait s'appliquer à toute pâte polymérisable, de polymère, ou de tout autre matériau isolant s'étalant selon un facteur DOP déterminé.

## Revendications

1. Procédé de formation d'un réseau multicouche (12) de connexion d'au moins un circuit intégré de haute densité, comprenant la formation sur une surface isolante (15a) d'une couche conductrice (16) pourvue de piliers (21), la formation sur la couche conductrice d'une couche isolante (17) à partir d'un matériau ayant un facteur DOP d'aplanissement, la gravure de la couche isolante pour découvrir les piliers, et la formation d'une seconde couche conductrice sur la couche isolante et en contact avec les piliers, caractérisé en ce qu'il consiste à accroître artificiellement le facteur DOP de la couche isolante en la stratifiant jusqu'à obtenir une surface supérieure (25a) présentant des marches d'une hauteur maximale (Sn) sensiblement égale ou inférieure à une valeur désirée (V), une seule couche étant suffisante si son facteur DOP est tel que la hauteur maximale des marches est égale ou inférieure à la valeur désirée (V), et en ce que la gravure est faite uniformément sur toute la surface de la couche isolante.

2. Procédé selon la revendication 1, caractérisé en ce qu'il consiste à déterminer le nombre n de strates de la couche isolante en le calculant en rapport avec le facteur DOP et avec la hauteur (H) des piliers par rapport à la surface isolante (15a) de façon que le produit H (1 - DOP)ⁿ corresponde à la valeur de la hauteur maximale (Sn) des marches.

3. Procédé selon la revendication 1 ou 2, caractérisé en ce que la couche isolante est faite à partir d'un matériau polymérisable.

4. Procédé selon la revendication 3, caractérisé en ce que chaque strate est formée d'une couche de pâte précuite à une température inférieure à la température de polymérisation.

5. Procédé selon la revendication 3 ou 4, caractérisé en ce que la gravure est effectuée avant polymérisation de la couche isolante stratifée.

6. Procédé selon la revendication 3 ou 4, caractérisé en ce que la gravure a lieu aprés polymérisation de la couche isolante stratifiée.

7. Procédé selon l'une des revendications 1 à 6, caractérisé en ce qu'il consiste à surélever initialement les piliers (21) de la couche conductrice d'une grandeur (e), à graver la couche isolante stratifée de façon à obtenir une couche placée sous la face supérieure des piliers de la grandeur (e), et à éliminer la partie supérieure (e) des piliers pour les rendre coplanaires à la surface de la couche isolante gravée.

8. Carte (10) de connexion d'au moins un circuit intégré de haute densité, comprenant un réseau (12) composé conductrices et isolantes alternées, chaque couche conductrice incluant des conducteurs surmontés de piliers (21), caractérisée en ce que les couches isolantes sont sensiblement coplanaires avec les faces supérieures des piliers (21) de la couche conductrice sous-jacente et sont constituées d'une ou plusieurs strates successives d'un matériau ayant un facteur d'aplanissement (DOP) permettant d'obtenir une surface présentant des marches d'une hauteur maximale inférieure à une valeur désirée (V).

9. Carte selon la revendication 8, caractérisée en ce que les couches isolantes sont faites d'un matériau polymérisé.

## Claims

1. A process for the formation of a multilayer network (12) for connecting at least one high-density integrated circuit, comprising the formation on an insulating surface (15a) of a conducting layer (16) provided with pillars (21), the formation on the conducting layer of an insulating layer (17) starting from a material having a planarisation (DOP) factor, the etching of the insulating layer to uncover the pillars, and the formation of a second conducting layer on the insulating layer and in contact with the pillars, characterised in that it consists of artificially increasing the DOP factor of the insulating layer by stratifying it until an upper surface (25a) is obtained having steps of a maximum height (Sn) substantially equal to or less than a desired value (V), a single layer being sufficient if its DOP factor is such that the maximum height of the steps is equal to or less than the desired value (V), and in that the etching is performed uniformly over the whole surface of the insulating layer.

2. A process according to Claim 1, characterised in that it consists of determining the number n of strata of the insulating layer and calculating this in relation to the DOP factor and to the height (H) of the pillars in relation to the insulating surface (15a) such that the product H (1 - DOP)ⁿ corresponds to the value for the maximum height (Sn) of the steps.

3. A process according to Claim 1 or 2, characterised in that the insulating layer is made from a polymerisable material.

4. A process according to Claim 3, characterised in that each stratum is formed from a layer of compound pre-baked at a temperature below the polymerisation temperature.

5. A process according to Claim 3 or 4, characterised in that the etching is performed before polymerisation of the stratified insulating layer.

6. A process according to Claim 3 or 4, characterised in that the etching is performed after polymerisation of the stratified insulating layer.

7. A process according to one of Claims 1 to 6, characterised in that it consists of initially raising the pillars (21) of the conducting layer by a magnitude (e), of etching the stratified insulating layer so as to obtain a layer placed below the upper face of the pillars of the magnitude (e), and of eliminating the upper portion (e) of the pillars to make them coplanar with the surface of the etched insulating layer.

8. A card (10) for connecting at least one high-density integrated circuit, comprising a network (12) composed [of] alternating conducting and insulating [layers], each conducting layer including conductors topped with pillars (21), characterised in that the insulating layers are substantially coplanar with the upper faces of the pillars (21) of the underlying conducting layer and are composed of one or more successive strata of a material having a planarisation factor (DOP) by which a surface may be obtained having steps of a maximum height of less than a desired value (V).

9. A card according to Claim 8, characterised in that the insulating layers are made of a polymerised material.

## Patentansprüche

1. Verfahren zur Herstellung eines mehrschichtigen Netzes (12) für den Anschluß wenigstens einer integrierten Schaltung hoher Dichte, bei dem eine mit Pfeilern (21) versehene leitende Schicht (16) auf einer isolierenden Oberfläche (15a) gebildet wird, eine isolierende Schicht (17) auf der leitenden Schicht ausgehend von einem Material gebildet wird, das einen DOP-Einebnungsfaktor besitzt, die isolierende Schicht zum Freilegen der Pfeiler geätzt wird, und eine zweite leitende Schicht auf der isolierenden Schicht in Kontakt mit den Pfeilern gebildet wird, dadurch gekennzeichnet, daß es darin besteht, den DOP-Faktor der isolierenden Schicht künstlich zu vergrößern, indem diese lagenweise bis zum Erhalt einer obenliegenden Fläche (25a) gebildet wird, die Stufen einer maximalen Höhe (Sn) aufweist, die im wesentlichen gleich oder kleiner als ein gewünschter Wert (V) ist, wobei eine einzige Schicht ausreicht, wenn ihr DOP-Faktor einen solchen Wert aufweist, daß die maximale Höhe der Stufen gleich oder kleiner als der gewünschte Wert (V) ist, und daß das Ätzen gleichmäßig auf der gesamten Oberfläche der isolierenden Schicht erfolgt.

2. Verfahren nach Anspruch 1, dadurch gekennzeichnet, daß es darin besteht, die Anzahl n von Lagen der isolierenden Schicht zu bestimmen, indem sie im Zusammenhang mit dem DOP-Faktor und der Höhe (H) der Stufen bezüglich der isolierenden Oberfläche (15a) berechnet wird, so daß das Produkt H(1-DOP)ⁿ dem Wert der maximalen Höhe (Sn) der Stufen entspricht.

3. Verfahren nach Anspruch 1 oder 2, dadurch gekennzeichnet, daß die isolierende Schicht ausgehend von einem polymerisierbaren Material hergestellt wird.

4. Verfahren nach Anspruch 3, dadurch gekennzeichnet, daß jede Lage durch eine Schicht aus einer Paste gebildet wird, die bei einer Temperatur vorgehärtet ist, die unterhalb der Polymerisationstemperatur liegt.

5. Verfahren nach Anspruch 3 oder 4, dadurch gekennzeichnet, daß das Ätzen vor der Polymerisation der lagenweise gebildeten isolierenden Schicht erfolgt.

6. Verfahren nach Anspruch 3 oder 4, dadurch gekennzeichnet, daß das Ätzen nach der Polymerisation der lagenweise gebildeten isolierenden Schicht stattfindet.

7. Verfahren nach einem der Ansprüche 1 bis 6, dadurch gekennzeichnet, daß es darin besteht, die Pfeiler (21) der leitenden Schicht anfänglich um einen Betrag (e) zu überhöhen, die lagenweise gebildete isolierende Schicht so zu ätzen, daß eine Schicht erhalten wird, die um den Betrag (e) unter der oberen Fläche der Pfeiler angeordnet ist, und den oberen Abschnitt (e) der Pfeiler zu beseitigen, um diese mit der Oberfläche der geätzten isolierenden Schicht koplanar zu machen.

8. Karte (10) zum Anschluß wenigstens einer integrierten Schaltung hoher Dichte mit einem Netz (12) von einer abwechselnd leitenden und isolierenden Zusammensetzung, wobei jede leitende Schicht Leiter enthält, auf denen Pfeiler (21) angebracht sind, dadurch gekennzeichnet, daß die isolierenden Schichten im wesentlichen mit den obenliegenden Flächen der Pfeiler (21) der unmittelbar darunterliegenden leitenden Schicht koplanar und durch eine oder mehrere aufeinanderfolgende Lagen aus einem Material gebildet sind, das einen Ausgleichsfaktor (DOP) besitzt, der es gestattet, eine Oberfläche zu erhalten, die Stufen einer maximalen Höhe aufweist, die kleiner als ein gewünschter Wert (V) ist.

9. Karte nach Anspruch 8, dadurch gekennzeichnet, daß die isolierenden Schichten aus einem polymerisierten Material hergestellt sind.
